# EUROPEAN PATENT APPLICATION

(11) **EP 4 648 284 A1**
(43) Date of publication of application: **12.11.2025**
(21) Application number: 24175007.4
(22) Date of filing: 09.05.2024
(51) Int. Cl.: H03K 17/082

(54) **SEMICONDUCTOR ARRANGEMENT AND METHOD FOR MONITORING A SEMICONDUCTOR ARRANGEMENT**

(71) Applicant: Infineon Technologies Austria AG, 9500 Villach (AT)
(72) Inventor: GROENER, Markus, 85356 Freising (DE); VERDUGO, Victor, 01309 Dresden (DE); TILKE, Armin, 01309 Dresden (DE)
(74) Representative: Westphal, Mussgnug & Partner, Patentanwälte mbB

(57) **Abstract**

A semiconductor arrangement and a method for operating a semiconductor arrangement are disclosed. The semiconductor arrangement includes: a plurality of semiconductor bodies (11, 12, 1n); a housing (3) in which the plurality of semiconductor bodies (11, 12) are arranged; and a sensor circuit (2) including a plurality of temperature sensors (21, 22, 2m),. In each of the semiconductor bodies (11, 12, 1n) at least one of the temperature sensors (21, 22, 2m) is integrated. Furthermore, each of the temperature sensors (21, 22, 2m) is connected between a first pin (31) and a second pin (32) of the housing (3).

## Description

This disclosure relates in general to a semiconductor arrangement, in particular a semiconductor arrangement including several semiconductor bodies arranged in a common housing.

Various types of semiconductor arrangements include several semiconductor bodies (dies) arranged in a common housing and each having a semiconductor device integrated therein. One example of a semiconductor arrangement of this type is a transistor arrangement that includes several transistors connected in parallel, wherein each transistor is integrated in a separate chip. The housing is a mold compound housing, for example.

In each of the semiconductor devices an overload condition, such as an overcurrent, may occur. The overload condition may result in an excessive heating of the semiconductor body in which the semiconductor device is integrated. Thus, the overload condition may be detected by monitoring the temperature of the semiconductor body. In a semiconductor arrangement including several semiconductor bodies arranged in the same housing, a temperature sensor may be placed in each of the semiconductor bodies and the temperature in each of the semiconductor bodies may be monitored individually. This, however, requires to provide monitoring pins for each of the temperature sensors at the housing, so as to be able to monitor a current or voltage provided by each temperature sensor. This, however, is space-consuming and expensive.

As an alternative, not each of the semiconductor bodies may include a temperature sensor, so that the temperature in those semiconductor bodies that do not include a temperature sensor is indirectly measured through temperature sensors in one or more other semiconductor bodies. This, however, is less precise.

There is a need to monitor a semiconductor arrangement including several semiconductor bodies arranged in a common housing for the occurrence of an overload condition.

One example relates to a semiconductor arrangement. The semiconductor arrangement includes a plurality of semiconductor bodies, a housing in which the plurality of semiconductor bodies are arranged, and a sensor circuit including a plurality of temperature sensors. In each of the semiconductor bodies at least one of the temperature sensors is integrated, and each of the temperature sensors is connected between a first pin and a second pin of the housing.

Another example relates to a method of monitoring a semiconductor arrangement for an overload condition. The semiconductor arrangement includes a plurality of semiconductor bodies and a sensor circuit including a plurality of temperature sensors connected in parallel, wherein in each of the semiconductor bodies at least one of the temperature sensors is integrated. Monitoring the semiconductor arrangement for the overload condition includes driving a sense current through the sensor circuit, measuring a voltage across the sensor circuit, and comparing the measured voltage with an overload condition threshold.

Examples are explained below with reference to the drawings. The drawings serve to illustrate certain principles, so that only aspects necessary for understanding these principles are illustrated. The drawings are not to scale. In the drawings the same reference characters denote like features.

Figures 1-3 illustrate different examples of semiconductor arrangements each including several semiconductor bodies arranged in a housing, and each including temperature sensors integrated in the semiconductor bodies and connected between first and second pins of the housing;
Figure 4 illustrates one example of a temperature sensor that includes several diodes connected in series;
Figure 5 and 6 illustrate different characteristic curves of a sensor arrangement including several temperature sensors connected between the first and second pins of the housing;
Figure 7 illustrates one example of an electronic circuit that includes a semiconductor arrangement in accordance with one of the examples illustrated in Figures 1-3, and a detection circuit;

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

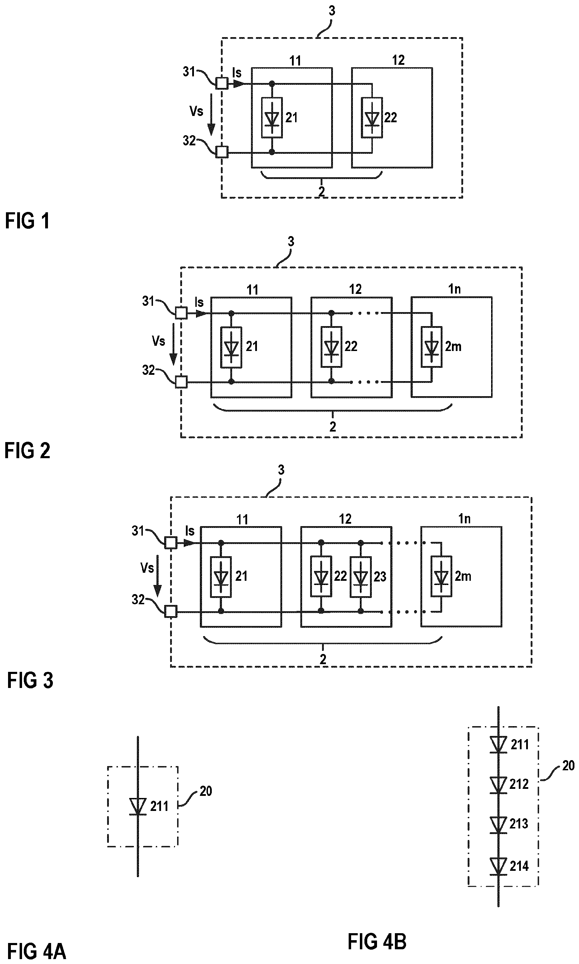

Figures 1-3 each schematically illustrate a top view of a semiconductor arrangement according to one example. The semiconductor arrangement includes a plurality of semiconductor bodies. The example illustrated in Figure 1 includes two semiconductor bodies 11, 12, and the examples illustrated in Figures 2 and 3 each include three semiconductor bodies 11, 12, 1n. It should be noted that the semiconductor arrangement is not restricted to include two or three semiconductor bodies. Instead, the semiconductor arrangement can be implemented with any number of more than two semiconductor bodies. According to one example, the number of semiconductor bodies in the semiconductor arrangement is between 2 and 20, in particular, between 2 and 12.

Referring to Figures 1-3, the semiconductor arrangement further includes a sensor arrangement 2 with a plurality of temperature sensors, wherein each of the semiconductor bodies 11, 12, 1n has at least one of the temperature sensors integrated therein. In the examples illustrated in Figures 1 and 2, exactly one temperature sensor 21, 22, 2m is integrated in each of the semiconductor bodies 11, 12, 1n. In the example illustrated in Figure 3, two semiconductor bodies 11, 1n have exactly one temperature sensor 21, 2m integrated therein and one semiconductor body 12 has two temperature sensors 22, 23 integrated therein. It should be noted that having one or two temperature sensors integrated in one semiconductor body is only an example. Basically, any number of temperature sensors can be integrated in each of the semiconductor bodies 11, 12, 1n. According to one example, the number of temperature sensors integrated in each of the semiconductor bodies11, 12, 1n is between 1 and 4 and is independent of the number of temperature sensors integrated in the other semiconductor bodies. According to one example, each of the semiconductor bodies 11, 12, 1n arranged in the same housing 3 has exactly one temperature sensor integrated therein.

Furthermore, each of the temperature sensors 21, 22, 23, 2m is connected between a first pin 31 and a second pin 32 of the housing 3, so that the temperature sensors 21, 22, 23, 2m of the sensor arrangement 2 are connected in parallel.

The housing 3, which is illustrated in dashed lines in the drawings, can be any type of housing that is suitable for accommodating the semiconductor bodies 11, 12, 1n and protecting the semiconductor bodies 11, 12, 1n from external influences, such as dust, moisture, or the like. The housing 3 is a mold compound housing, for example.

The first and second pins 31, 32 provide for electrical access to the temperature sensors from outside the housing 3. That is, a current or a voltage may be applied to the temperature sensors 21, 22, 2m arranged inside the housing 3 via the first and second pins 31, 32. Electrical connections between the temperature sensors 21, 22, 2m and the first and second pins 31,. 32 are only schematically illustrated in Figures 1-3.

By connecting the temperature sensors 21, 22, 23, 2m to the same first and second pins 31, 32 a low pin count can be achieved independent of the number of temperature sensors included in the semiconductor arrangement. Nevertheless, an overload condition occurring in one of the semiconductor bodies 11, 12, 1n and resulting in an excessive heating of the respective semiconductor body 11, 12, 1n can be detected rather precisely. This is explained in detail herein further below.

According to one example each temperature sensor includes at least one diode. Different examples of a temperature sensor 20 that includes at least one diode are illustrated in Figures 4A and 4B. The temperature sensor 20 illustrated in Figures 4A and 4B represents an arbitrary one of the temperature sensors 21, 22, 23, 2m illustrated in Figures 1-3 and explained above.

Referring to Figure 4A, the temperature sensor 20 includes one diode 211. According to another example illustrated in Figure 4B, the temperature sensor 20 includes several diodes 211-214 connected in series. In the example illustrated in Figure 4B, four diodes are connected in series. This, however, is only an example. Any number of diodes may be connected in series to form the temperature sensor. According to one example, the number of diodes connected in series is between 2 and 10.

It is commonly known that with a diode that is operated in a forward biased mode at a given temperature, the current through the diode exponentially increases as the voltage forward biasing the diode increases. Furthermore, at a given voltage forward biasing the diode, the current through the diode exponentially increases as the temperature increases and, at a given current through the diode, the voltage across the diode linearly decreases as the temperature increases. Operating a diode as a temperature sensor may include driving a current with a predefined current level through the diode and measuring the voltage across the diode. The voltage across the diode provides a measure of the temperature and decreases as the temperature increases.

It should be noted that implementing the temperature sensors 21, 22, 23, 2m to include at least one diode is only an example. Any the other type of electronic device may be used as a temperature sensor element in the temperature sensors 21, 22, 23, 2n that exhibits a super linear increase of the current through the electronic device when the temperature increases and when a predefined voltage is applied to the electronic device. Just for the purpose of explanation, it is assumed that the temperature sensors 21, 22, 23, 2m are implemented to include one or more diodes. The explanation provided in the following, however, applies to temperature sensors implemented with other types of sensor elements having a super linear dependency of the current through the sensor element on the temperature.

According to one example, the temperature sensors 21-2m of the temperature arrangement 2 at least approximately have the same temperature characteristic. According to one example, this includes that a voltage across each of the temperature sensors of the temperature arrangement 2 is approximately the same when the same current is driven through each of the temperature sensors. Temperature sensors having the same temperature characteristic can be obtained, for example, by connecting the same number of sensor elements, such as diodes, in series and by using sensor elements, such as diodes, having the same temperature characteristic.

Referring to the above, the voltage across a diode, resulting from a constant current through the diode, (linearly) decreases as the temperature of the diode increases, while the current through the diode resulting from a constant forward biasing voltage, applied to the diode, exponentially increases as the temperature increases. With a temperature sensor including at least one diode, the voltage drop across the temperature sensor (linearly) decreases as the temperature of the temperature sensor increases when a constant current is driven through the temperature sensor. The voltage drop at the sensor is approximately proportional to the number of diodes connected in series in the temperature sensor. Furthermore, with a temperature sensor including at least one diode, a current through the temperature sensor exponentially increases when a predefined voltage is applied across the temperature sensor and the temperature increases

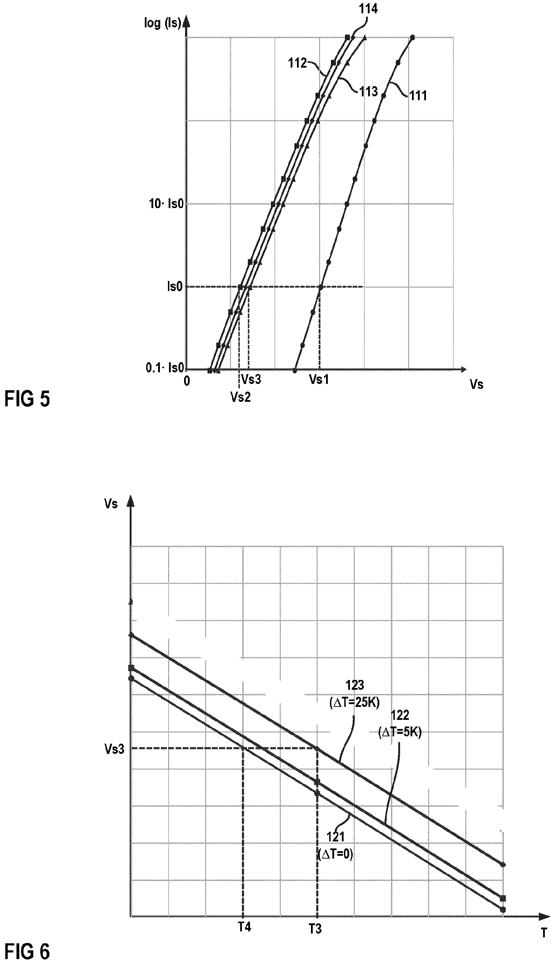

The exponential dependency of the current through the temperature sensor on the temperature has the effect that in the temperature arrangement 2 with several temperature sensors 21-2m connected in parallel the temperature sensor having the highest temperature takes over the majority of the current driven through the sensor arrangement 2 and governs the overall resistance of the sensor arrangement 2. This is explained with reference to Figures 5 and 6 in the following.

Figure 5 shows different curves that each illustrate the current Is through a sensor arrangement 2 connected to the first and second pins 31, 32 over the voltage Vs across the sensor arrangement 2 at a respective temperature. The "voltage Vs across the sensor arrangement 2" is the voltage between the first and second pins 31, 32. In Figure 5, the current Is is illustrated on a logarithmic scale, the voltage Vs is illustrated on a linear scale, beginning with zero.

The curves illustrated in Figure 5 relate to a sensor arrangement 2 that includes two temperature sensors that are arranged spaced apart from each other. According to one example, the two temperature sensors are arranged in different semiconductor bodies in the same housing.

In Figure 5, the relationship between the current Is into the sensor arrangement 2 and the voltage Vs across the sensor arrangement 2 is illustrated for different operating scenarios, (a) a first scenario represented by curve 111 in which both temperature sensors have a same first temperature T1; (b) a second scenario represented by curve 112 in which both temperature sensors have a same second temperature T2 higher than the first temperature T1; (c) a third scenario represented by curve 113 in which one of the two temperature sensors has the first temperature T1 and the other one of the two temperature sensors has the second temperature T2; and (d) a fourth scenario represented by curve 114 in which one of the two temperature sensors has the second temperature T2 and the other one of the two temperature sensors has a third temperature higher than the first temperature T1 and lower than the second temperature T2.

The first temperature T1 is 25 °C (298 K), for example, the second temperature T2 is 175 °C (448 K), for example, and the third temperature T3 is 150 °C (423 K), for example.

At a given current Is0, the voltage across the sensor arrangement 2 has a first voltage level Vs1 in the first scenario (curve 111), has a second voltage level Vs2 lower than the first voltage level in the second scenario (curve 112), and has a third voltage level V3 higher than the first voltage level Vs1 and lower than the second voltage level Vs2 in the third scenario (curve 113). As can be seen from Figure 5, the relationship between the individual voltages Vs1, Vs2, Vs3 is essentially the same over a rather wide range of the current Is.

Referring to the above, at a given current through one temperature sensor, the voltage across the temperature sensor decreases as the temperature increases. This can be seen from curves 111 and 112 illustrated in Figure 6. Curves 111 and 112 have been obtained for a sensor arrangement that includes two temperature sensors having the same temperature characteristic connected in parallel and operated at the same temperature, the first temperature T1 in the scenario illustrated by curve 111 and the second temperature T2 in the scenario illustrated by curve 112. Curves 111 and 112 that have been obtained using a sensor arrangement 2 with two temperature sensors connected in parallel equivalently apply to a single temperature sensor receiving 50% of the current Is0 driven through the sensor arrangement 2.

Referring to the above, at a given voltage applied to one temperature sensor, the current through the temperature sensor exponentially increases as the temperature increases. In other words, the electrical resistance of the temperature sensor exponentially decreases as the temperature increases. The exponential increase of the current through one temperature sensor and the exponential decrease of the resistance of one temperature sensor at an increasing temperature has the effect that in a sensor arrangement including a parallel circuit with two or more temperature sensors the temperature sensor having the highest temperature takes over the majority of the current driven into the sensor arrangement and dominates the overall resistance of the sensor arrangement. This can be seen by comparing curves 112 and 113 in Figure 5. Referring to the above, curve 113 represents the scenario in which one of the two temperature sensors has the first temperature T1, such as 25 °C, and the other one of the two temperature sensors has the second temperature T2, such as 175 °C. The voltage Vs3 obtained in the third scenario is very close to the voltage Vs2 obtained in the second scenario, in which both temperature sensors have the second temperature T2, and the voltage Vs3 is much higher than the voltage Vs1 in the first scenario, in which both temperature sensors have the first temperature T1.

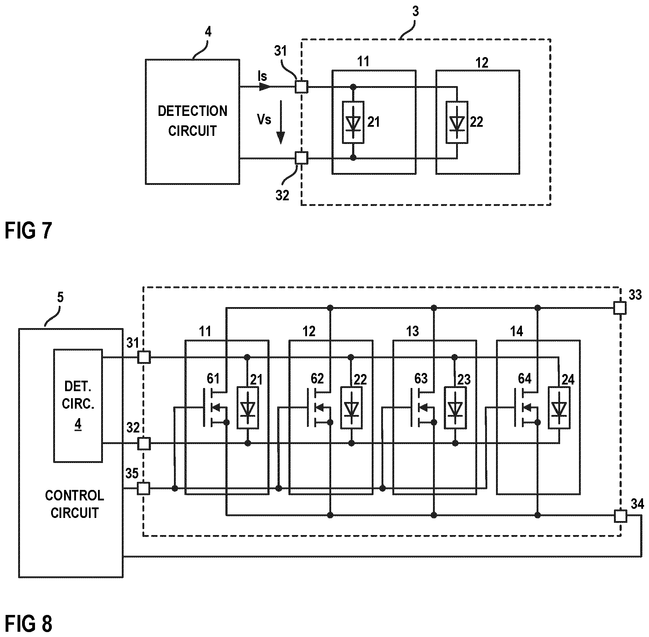

Figure 6 illustrates the voltage Vs across the sensor arrangement 2 when a given current Is0 flows through the sensor arrangement. Figure 6 relates to an example in which the sensor arrangement 2 includes two temperature sensors connected in parallel. The different curves 121-123 shown in Figure 7 illustrate the voltage Vs across the sensor arrangement 2 dependent on the temperature T for the case that that one of the two temperature sensors has a higher temperature. Each of curves 121-123 illustrates the voltage Vs across the temperature T at a different temperature difference ΔT between the two temperature sensors. (i) Curve 121 represents a scenario in which both temperature sensors have the same temperature, so that ΔT=0; (ii) curve 122 represents a scenario in which a temperature difference is 5K; and (iii) curve 123 represents a scenario in which the temperature difference is 25K. Both the temperature T and the voltage Vs are shown on a linear scale in Figure 6.

Based on Figure 6 an improvement can be seen that can be achieved by connecting temperature sensors arranged in a first semiconductor body and a second semiconductor body in parallel, as compared to a conventional approach in which a temperature sensor is arranged only in the first semiconductor body. In the conventional approach, the temperature is measured in the first semiconductor body directly using the temperature sensor and is measured in the second semiconductor body indirectly using the temperature sensor arranged in the first semiconductor body.

For the purpose of explanation it is assumed that the temperature in each of the two semiconductor bodies should not exceed a predefined temperature T3, which is selected from a range of between 150 °C and 180 °C, for example. This temperature T3 is referred to as overload temperature in the following.

For the purpose of explanation it is further assumed that due to a thermal resistance between the two semiconductor bodies a rapid temperature increase resulting from an overload condition in one of the two semiconductor bodies results in a delayed increase of the temperature in the other one of the two semiconductor bodies, so that in a transient phase, which is an operating phase in which the temperature in one of the two semiconductor bodies increases, there is a temperature difference between the temperatures in the two semiconductor bodies. For the purpose of explanation it is further assumed that the value ΔTo of this temperature difference resulting from the thermal resistance between the semiconductor bodies in the transient phase is known. Thus, when the temperature in one of two semiconductor bodies reaches the temperature value T3 due to an overload condition, the temperature in the other one of the two semiconductor bodies has reached a lower temperature T3-ΔTo.

In the conventional approach, in which the temperature sensor is integrated only in the first semiconductor body, it has to be assumed that an overload condition has occurred in the second semiconductor body when the temperature in the first semiconductor body has reached T3-ΔTo. This does not take into account that a temperature of T3-ΔTo in the first semiconductor body may also result from operating conditions of the semiconductor device integrated in the first semiconductor body without an overload condition having occurred in the second semiconductor body. Thus, an overload condition may erroneously be detected. The higher the temperature difference ΔTo that is taken into account the higher the probability that the temperature in the first semiconductor body reaches the threshold of T3-ΔTo without an overload condition having occurred in the second semiconductor body. If, for example, ΔTo=25K and the temperature in each of the two semiconductor body should not exceed 150 °C an overload condition will be detected when the temperature in the first semiconductor body reaches 125 °C (=150 °C-25K).

Referring to Figure 6, when a temperature sensor is integrated in each of the two semiconductor body and the temperature sensors are connected in parallel, the voltage Vs across the sensor arrangement with the two temperature sensors equals Vs3 when the temperature of one of the two semiconductor bodies equals T3 and the temperature of the other one of the two semiconductor bodies is 25K lower. This can be seen from curve 123, which illustrates the voltage Vs dependent on the temperature in the hotter one of the two semiconductor bodies and when the temperature difference ΔT is 25K. For the purpose of explanation it is assumed that Vs3 is in overload condition threshold, wherein an overload condition is detected when the voltage Vs reaches or falls below the overload condition threshold Vs3.

Referring to the above, the voltage Vs may reach the overload condition threshold when the temperature in one of the two semiconductor bodies equals T3 and the temperature in the other one of the two semiconductor bodies equals T3-25K. Thus, in the event that the voltage Vs being equal to the overload condition threshold Vs3 results from an operating scenario in which the temperature in one of the two semiconductor bodies equals T3 and the temperature in the other one of the two semiconductor bodies equals T3-25K an overload condition is correctly detected.

Referring to Figure 6, however, the overload condition threshold Vs3 may also be reached when both semiconductor bodies have the same temperature T4, which is lower than T3 but higher than T3-25K. In this operating scenario, the temperature in none of the two semiconductor bodies has reached the overload temperature T3, so that an overload condition is erroneously detected. In the example illustrated in Figure 6, T3=150 °C and T4=141 °C, for example.

As compared to the conventional approach, that uses only one temperature sensor in one of the two semiconductor bodies, the difference between the overload condition threshold T3 and the temperature T4 at which an overload condition is erroneously detected is only 9K (150 °C - 141 °C) as compared to 25K (150 °C - 125 °C) in the conventional approach. Thus, the probability of erroneously detecting an overload condition is significantly lower when using a sensor arrangement that includes several temperature sensors connected in parallel as compared to the conventional approach that uses only one temperature sensor in one of the semiconductor bodies.

Referring to Figure 7, the semiconductor arrangement may further include a detection circuit 4 that is connected to the first and second pins 31, 32 and that is configured to detect the overload condition. According to one example, for detecting the overload condition, the detection circuit 4 is configured to drive a sense current Is with a predefined current level via the first and second pins 31, 32 into the sensor arrangement 2 with the parallel connected temperature sensors 21, 22. Furthermore, the detection circuit 4 is configured to sense the voltage Vs between the first and second pins 31, 32, compare the voltage Vs with a predefined overload condition threshold, and detect an overload condition when the voltage Vs reaches or falls below the overload condition threshold.

Upon detecting the overload condition the detection circuit 4 may output an overload signal indicating the occurrence of the overload condition. A controller (not shown) configured to control operation of the semiconductor devices arranged in the semiconductor bodies 11, 12 of the semiconductor arrangement may receive the overload signal and take suitable measures, such as deactivating one or more of the semiconductor devices. According to one example, the detection circuit 4 is integrated in the controller for controlling operation of the semiconductor devices.

In the example illustrated in Figure 7, the sensor arrangement 2 includes two temperature sensors 21, 22, wherein each of these temperature sensors 21, 22 is integrated in a respective semiconductor body 11, 12. This, however, is only an example. The operating principle of the detection circuit 4 is independent of the specific implementation of the sensor arrangement 2 and applies to any of the sensor arrangements explained herein before accordingly.

Referring to the above, at least one semiconductor device may be integrated in each of the semiconductor bodies arranged in the housing 3. According to one example illustrated in Figure 8, a transistor device 61-64 is integrated in each of the semiconductor bodies 11-14. The transistor devices are schematically represented by circuit symbols. Just for the purpose of illustration, the circuit symbols illustrated in Figure 8 represent transistor devices implemented as N-type enhancement MOSFETs. This, however, is only an example. Any type of transistor devices may be implemented in the semiconductor bodies 11-14. This includes other types of MOSFETs than N-type enhancement MOSFETs, JFETs, IGBTs, bipolar junction transistors (BJTs), or HEMTs.

According to one example, the transistor devices are silicon carbide (SiC) devices.

In the example illustrated in Figure 8, the semiconductor arrangement includes four semiconductor bodies 11-14, wherein each of the semiconductor bodies 11-14 has one transistor device 61-64 integrated therein. Implementing the semiconductor arrangement with four transistor devices 61-64, however, is only an example. The semiconductor arrangement may include an arbitrary number of semiconductor bodies each having at least one transistor device integrated therein. According to one example, the semiconductor arrangement includes between 2 and 10 semiconductor bodies each having a transistor devices integrated therein.

According to one example, as illustrated in Figure 8, the transistor devices are connected in parallel. This includes that first load path nodes of the individual transistor devices are connected to a first load path pin 33 of the housing 3, second load path node of the individual transistor devices are connected to a second load path pin 34 of the housing 3, and control nodes of the transistor devices are connected to a control pin 35. in the example illustrated in Figure 8, in which the transistor devices are MOSFETs, the first load path nodes are drain and nodes, the second load path node are source nodes, and the control nodes are gate node of the MOSFETs.

A control circuit 5 is configured to control operation of the parallel connected transistor devices 61-64. According to one example, the transistor devices are a voltage-controlled transistor devices, such as MOSFETs, JFETs, or IGBTs, that switch on or off dependent on a voltage applied between a control node and one of the load path nodes. A MOSFET or a JFET, for example, switches on or off dependent on a voltage applied between the gate node and the source node.

In this example, as illustrated in Figure 8, the control circuit 5 is connected to the control pin 35 and the second load path pin 34 and is configured to control operation of the parallel connected transistor devices 61-64 by applying a suitable drive voltage (gate-source voltage) between the control pin 35 and the second load path pin 34. According to one example, the transistor devices are in an on-state (conducting state) when the drive voltage is higher than a threshold voltage of the transistor devices, and are in an off-state (blocking state) when the drive voltage is lower than the threshold voltage.

Referring to Figure 8, a temperature sensor 21-24 is integrated in each of the semiconductor bodies 11-14. The temperature sensors 21-24 are connected in parallel and connected to the first and second pins 31, 32, which are connected to the detection circuit 4. According to one example, the detection circuit 4 is integrated in the control circuit 5. According to one example, the control circuit 5 is configured to switch off the transistor devices 61-64 when the detection circuit 4, by monitoring the voltage Vs and comparing the voltage Vs with an overload condition threshold, detects an overload condition.

In the examples explained herein before, at least one temperature sensor is integrated in each of the semiconductor bodies of the semiconductor arrangement. According to another example (not illustrated) the semiconductor arrangement includes at least two semiconductor bodies that each have at least one temperature sensor integrated therein, wherein the temperature sensors are connected in parallel. Furthermore, the semiconductor arrangement includes at least one further semiconductor body that does not have a temperature sensor integrated therein. In this example, the temperature in the semiconductor bodies not having a temperature sensor integrated therein is indirectly measured via the sensor arrangement including the two or more temperature sensors connected in parallel and connected to the first and second pins.

Some of the aspects explained above are briefly summarized in the following with reference to numbered examples.

Example 1. A semiconductor arrangement, including: a plurality of semiconductor bodies; a housing in which the plurality of semiconductor bodies are arranged; and a sensor circuit including a plurality of temperature sensors, wherein in each of the semiconductor bodies at least one of the temperature sensors is integrated, and wherein each of the temperature sensors is connected between a first pin and a second pin of the housing.

Example 2. The semiconductor arrangement according to example 1, further including a detection circuit configured to: drive a current via the first and second pins through the sensor circuit; sense a voltage between the first and second pins; and monitor the semiconductor arrangement for an overload condition dependent on the sensed voltage between the first and second pins.

Example 3. The semiconductor arrangement according to example 2, wherein the detection circuit, to monitor the semiconductor arrangement for the overload condition, is configured to compare the sensed voltage between the first and second pins with an overload condition threshold, and detect the overload condition when the sensed voltage meets a predefined condition with regard to the overload condition threshold.

Example 4. The semiconductor arrangement according to example 3, wherein the sensed voltage meets the predefined condition when the sensed voltage is equal to or lower than the overload condition threshold.

Example 5. The semiconductor arrangement according to any one of examples 1 to 4, wherein the temperature sensors have at least approximately the same temperature characteristic.

Example 6. The semiconductor arrangement according to any one of examples 1 to 5, wherein each of the temperature sensors includes at least one sensor element which, at a given voltage applied to the sensor element, has a super linear dependency of a current through the temperature sensor on the temperature.

Example 7. The semiconductor arrangement according to example 6, wherein the sensor element is a diode.

Example 8. The semiconductor arrangement according to example 7, wherein each of the temperature sensors includes a plurality of diodes connected in series.

Example 9. The semiconductor arrangement according to any one of the preceding examples, further including: a semiconductor device integrated in each of the semiconductor bodies, wherein each of the semiconductor devices is connected to at least one further pin different from the first and second pins.

Example 10. The semiconductor arrangement according to example 9, wherein each of the semiconductor devices is a transistor device.

Example 11. The semiconductor arrangement according to example 10, wherein the at least one further pin includes a first load path pin, a second load path pin, and a control pin, and wherein each of the transistor devices includes a first load path node connected to the first load path pin, a second load path node connected to the second load path node pin, and a control node connected to the control pin.

Example 12. The semiconductor arrangement according to example 10 or 11, wherein the transistor devices are MOSFETs or JFETs.

Example 13. The semiconductor arrangement according to any one of the preceding examples, wherein the semiconductor bodies are silicon carbide, SiC, semiconductor bodies.

Example 14. A method, including: monitoring a semiconductor arrangement for an overload condition, wherein the semiconductor arrangement includes: a plurality of semiconductor bodies; and a sensor circuit including a plurality of temperature sensors connected in parallel, wherein in each of the semiconductor bodies at least one of the temperature sensors is integrated, and wherein monitoring the semiconductor arrangement for the overload condition includes: driving a sense current through the sensor circuit; measuring a voltage across the sensor circuit; and comparing the measured voltage with an overload condition threshold.

Example 15. The method according to example 14, wherein the semiconductor arrangement further includes a housing in which the plurality of semiconductor bodies are arranged, and wherein each of the temperature sensors is connected between a first pin and a second pin of the housing.

Example 16. The method according to example 14 or 15, wherein monitoring the semiconductor arrangement for the overload condition includes: comparing the sensed voltage between the first and second pins with an overload condition threshold, and detecting the overload condition when the sensed voltage meets a predefined condition with regard to the overload condition threshold.

Example 17. The method according to example 16, wherein the sensed voltage meets the predefined condition when the sensed voltage is equal to or lower than the overload condition threshold.

Example 18. The method according to any one of examples 14 to 17, wherein the temperature sensors have at least approximately the same temperature characteristic.

Example 19. The method according to any one of examples 14 to 18, wherein each of the temperature sensors includes at least one sensor element which, at a given voltage applied to the sensor element, has a super linear dependency of a current through the temperature sensor on the temperature.

## Claims

1. A semiconductor arrangement, comprising:
a plurality of semiconductor bodies (11, 12, 1n);
a housing (3) in which the plurality of semiconductor bodies (11, 12) are arranged; and
a sensor circuit (2) comprising a plurality of temperature sensors (21, 22, 2m),
wherein in each of the semiconductor bodies (11, 12, 1n) at least one of the temperature sensors (21, 22, 2m) is integrated, and
wherein each of the temperature sensors (21, 22, 2m) is connected between a first pin (31) and a second pin (32) of the housing (3).

2. The semiconductor arrangement according to claim 1, further comprising a detection circuit (4) configured to:
drive a current (Is) via the first and second pins (31, 32) through the sensor circuit (2);
sense a voltage (Vs) between the first and second pins (31, 32); and
monitor the semiconductor arrangement for an overload condition dependent on the sensed voltage between the first and second pins (31, 32).

3. The semiconductor arrangement according to claim 2,
wherein the detection circuit (4), to monitor the semiconductor arrangement for the overload condition, is configured to
compare the sensed voltage (Vs) between the first and second pins (31, 32) with an overload condition threshold, and
detect the overload condition when the sensed voltage (Vs) meets a predefined condition with regard to the overload condition threshold.

4. The semiconductor arrangement according to claim 3,
wherein the sensed voltage (Vs) meets the predefined condition when the sensed voltage (Vs) is equal to or lower than the overload condition threshold.

5. The semiconductor arrangement according to any one of claims 1 to 4,
wherein the temperature sensors (21, 22, 2m) have at least approximately the same temperature characteristic.

6. The semiconductor arrangement according to any one of claims 1 to 5,
wherein each of the temperature sensors (21, 22, 2m) comprises at least one sensor element which, at a given voltage applied to the sensor element, has a super linear dependency of a current through the temperature sensor on the temperature.

7. The semiconductor arrangement according to claim 6,
wherein the sensor element is a diode.

8. The semiconductor arrangement according to claim 7,
wherein each of the temperature sensors (21, 22, 2m) comprises a plurality of diodes (211-214) connected in series.

9. The semiconductor arrangement according to any one of the preceding claims, further comprising:
a semiconductor device (61-64) integrated in each of the semiconductor bodies (1, 2),
wherein each of the semiconductor devices (61-64) is connected to at least one further pin (33, 34, 35) different from the first and second pins (31, 32).

10. The semiconductor arrangement according to claim 9,
wherein each of the semiconductor devices (61-64) is a transistor device.

11. The semiconductor arrangement according to claim 10,
wherein the at least one further pin comprises a first load path pin (33), a second load path pin (34), and a control pin (35), and
wherein each of the transistor devices (61-64) comprises a first load path node connected to the first load path pin (33), a second load path node connected to the second load path node pin (34), and a control node connected to the control pin (35).

12. The semiconductor arrangement according to claim 10 or 11,
wherein the transistor devices are MOSFETs or JFETs.

13. A method, comprising:
monitoring a semiconductor arrangement for an overload condition,
wherein the semiconductor arrangement comprises:
a plurality of semiconductor bodies (11, 12, 1n); and
a sensor circuit (2) comprising a plurality of temperature sensors (21, 22, 2m) connected in parallel, wherein in each of the semiconductor bodies (11, 12, 1n) at least one of the temperature sensors (21, 22, 2m) is integrated, and
wherein monitoring the semiconductor arrangement for the overload condition comprises:
driving a sense current (Is) through the sensor circuit (2);
measuring a voltage (Vs) across the sensor circuit (2); and
comparing the measured voltage (Vs) with an overload condition threshold.

14. The method according to claim 13,
wherein the semiconductor arrangement further comprises a housing (3) in which the plurality of semiconductor bodies (11, 12, 1n) are arranged, and
wherein each of the temperature sensors (21, 22, 2m) is connected between a first pin (31) and a second pin (32) of the housing.

15. The method according to claim 13 or 14, wherein monitoring the semiconductor arrangement for the overload condition comprises:
comparing the sensed voltage (Vs) between the first and second pins (31, 32) with an overload condition threshold, and
detecting the overload condition when the sensed voltage (Vs) meets a predefined condition with regard to the overload condition threshold.
